# EUROPEAN PATENT APPLICATION

(11) **EP 0 984 458 A1**
(43) Date of publication of application: **08.03.2000**
(21) Application number: 98912789.9
(22) Date of filing: 14.04.1998
(51) Int. Cl.: H01B 12/02, H01B 13/00

(54) **WIRE FOR COMPOUND SUPERCONDUCTING CABLES AND METHOD OF PRODUCING THE SAME**

(30) Priority: 14.04.1997 JP 9612797
(71) Applicant: Sumitomo Electric Industries, Ltd., Osaka-shi, Osaka 541-0041 (JP)
(72) Inventor: AYAI, Naoki-Osaka Works of Sumitomo Electric Ind., Osaka-shi, Osaka 554-8511 (JP); YAMADA, Yuichi-Osaka Works of Sumitomo Elec. Ind., Osaka-shi, Osaka 554-8511 (JP)
(74) Representative: Grünecker, Kinkeldey, Stockmair & Schwanhäusser Anwaltssozietät
(86) International application number: JP9801694
(87) International publication number: WO9847156

(57) **Abstract**

A laminated sheet 3a formed by an Nb-containing sheet 1a and an Al-containing sheet 2a and a laminated sheet 3b formed by an Nb-containing sheet 1b and an Al-containing sheet 2b are superposed and rolled up so that the Nb-containing sheets and the Al-containing sheets alternately overlap with each other. Thus, a wire for a compound superconducting wire excellent in productivity and a method of manufacturing the same can be obtained without deteriorating superconducting characteristics and workability.

## Description

### Technical Field

The present invention relates to a wire for a compound superconducting wire used for a superconducting magnet which can be employed for nuclear fusion, superconducting energy storage, a particle accelerator or other use and a method of manufacturing the same.

### Background Technique

The upper critical magnetic field of NbTi most widely used at present as a superconducting material for a practical superconducting wire at 4.2 K is about 10 T. On the other hand, a compound superconductor such as Nb₃Sn has a high critical magnetic field exceeding 20 T and can generate a high magnetic field which cannot be implemented with NbTi. However, the compound superconductor is so poor in ductility that it is difficult to directly work the same into the state of a wire. Therefore, in the case of Nb₃Sn, for example, a method of compositing Nb and a Cu-Sn alloy or the like and working the same into a wire and thereafter forming Nb₃Sn which is a superconductor in the superconducting wire by reaction through heat treatment is employed.

Nb₃Al, which is a compound superconductor having higher critical temperature and critical magnetic field than Nb₃Sn, has such an advantage that deterioration of these characteristics resulting from distortion is small. While it has been difficult to work Nb₃Al into a wire since the same is formed only at a high temperature dose to 2000°C, it has been proved that Nb₃Al is formed at a relatively low temperature by extremely reducing the distance between Nb-Al pairs by a jelly roll method, a powder method or the like. A copper-stabilized multi-filamentary wire having practical characteristics is verified particularly in the jelly roll method among these.

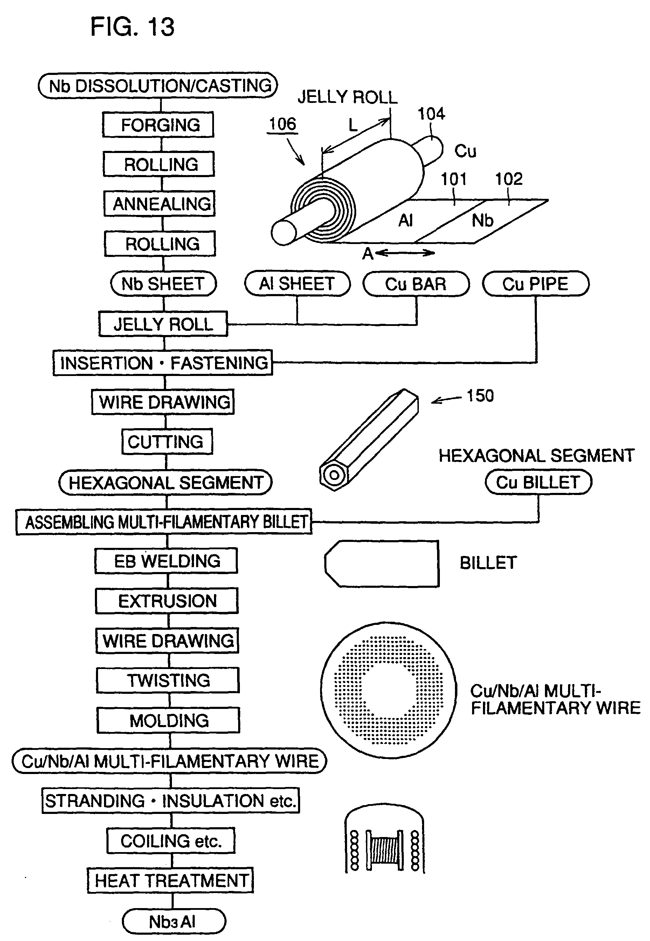

A method of manufacturing a wire of Nb₃Al by the jelly roll method is now described with reference to Fig. 13.

Referring to Fig. 13, an Al sheet 101 of high purity and an Nb sheet 102 of high purity are first prepared by dissolution and rolling. Then, a roll laminate (jelly roll) 106 is prepared by superposing and rolling up this Al sheet 101 and the Nb sheet 102 around a copper bar 104. Then, a hexagonal segment 150 is obtained by inserting this roll laminate 106 into a copper pipe, thereafter drawing the same, forming the section in a hexagonal shape, and thereafter cutting the same in a desired length.

Then, a plurality of hexagonal segments 150 are charged in a copper pipe so that a billet is prepared, thereafter the billet is sealed up by electron beam welding in a vacuum, and extrusion is performed. Then, wire drawing is performed on a multi-filamentary wire formed in this manner, and the distance between Nb-Al pairs is reduced to not more than 1 µm, for example. Thereafter desired twisting, molding, stranding, insulation and the like are performed and coiling is further performed, and thereafter heat treatment is performed at a temperature of at least 700°C, for example, so that a superconducting phase (A15 structure of Nb₃Al) is formed.

In order to ensure superconducting characteristics such as a critical current density, several 10 layers are generally necessary as for the number of layers of the sheets 101 and 102 of the roll laminate 106 (Fig. 13). This number of layers is decided by the length of the sides of the sheets 101 and 102 in the laminate direction (direction of arrow A).

Considering formation of the roll laminate 106 and the efficiency yield of subsequent wire working, it is desirable that the length L of the roll laminate 106 is large to some extent. The length L of the roll laminate is decided by the length of the sides of the sheets 101 and 102 perpendicular to the laminate direction (direction of arrow A).

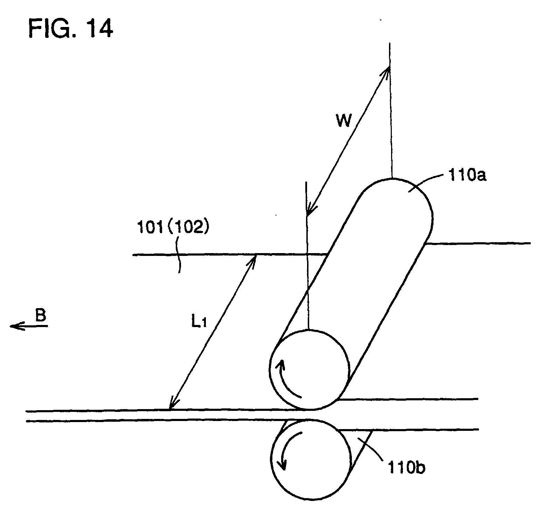

Thus, ideal values are decided from requirements for the characteristics, the efficiency and the yield as to the sizes of the sheets 101 and 102, while the sizes of manufacturable sheets are limited in practice. More specifically, the sheets 101 and 102 are prepared by rolling as shown in Fig. 14 and hence the size thereof can be considerably lengthened in the rolling direction (direction of arrow B), while the size in the direction perpendicular to the rolling direction is limited by the width W of rolls 110a and 110b of a rolling mill.

In other words, when employing the rolling direction B shown in Fig. 14 as the laminate direction A shown in Fig. 13, the length L of the roll laminate 106 is limited and the manufacturing efficiency as well as the yield are sacrificed although the number of layers can be increased. When employing the direction perpendicular to the rolling direction B shown in Fig. 14 as the laminate direction A shown in Fig. 13, on the other hand, there has been such a problem that the number of layers is limited and the superconducting characteristics of the superconducting wire are sacrificed although the length L of the roll laminate 106 can be increased.

### Disclosure of the Invention

An object of the present invention is to provide a wire for a compound superconducting wire excellent in productivity and a method of manufacturing the same without deteriorating superconducting characteristics and workability.

A method of manufacturing a wire for a superconducting wire according to one aspect of the present invention is a method of superposing and rolling up an Nb-containing sheet consisting of pure Nb or an alloy containing Nb and an X-containing sheet consisting of a metallic atom X reacting with Nb and forming a compound exhibiting superconductivity or an alloy containing X with each other, and comprises the following steps:

First, a first laminated sheet obtained by superposing a first Nb-containing sheet and a first X-containing sheet and a second laminated sheet obtained by superposing a second Nb-containing sheet and a second X-containing sheet are prepared. The first and second laminated sheets are superposed and rolled up so that the Nb-containing sheets and the X-containing sheets alternately overlap with each other.

At least two laminated sheets are thus employed, and hence a sufficient number of layers can be ensured even if employing short sides of the sheets decided by a reduction roll width for a laminate direction for a roll laminate.

Thus, it is possible to employ long sides in a roll direction for the length direction of the roll laminate, and elongation of the roll laminate can be readily attained without increasing the size of rolling equipment.

While the roll laminate is worked into a single-filamentary wire by extrusion or wire drawing, it is unavoidable that a terminal portion of a constant length decided by working equipment sustains a loss. However, the length of a non-defective portion increases with respect to the length of the loss portion due to elongation of the roll laminate, and such a yield that non-defective products are obtained from supplied materials is improved as a result.

Further, the number of roll laminates necessary for obtaining a prescribed final product reduces due to elongation of the roll laminate, and preparation of the roll laminate as well as preparation efficiency for a single-filamentary segment subsequent thereto are also improved.

When superposing the first and second laminated sheets so that the Nb-containing sheets or the X-containing sheets were in contact with each other, reduction of the critical current value was observed. This is conceivably because the formation volume ratio of a compound superconductor reduces or the stoichiometric composition of the formed compound deteriorates since the sizes of the layers in the laminate increase in connected portions and the ratio of Nb and X contained in a unit sectional area deviates from a designed value.

In the manufacturing method according to the present invention, the Nb-containing sheets and the X-containing sheets are alternately stacked also in the connected portions, and there is no problem of the aforementioned deterioration of the characteristics.

When trying to roll a substance obtained by alternately simply superposing Nb-containing sheets and X-containing sheets in plural, the roll diameter is smaller in a portion dose to a roll starting portion, and the total thickness of the rolled sheets increases. When rolling at least two laminated sheets, therefore, it is difficult to tightly roll the sheets as compared with the case of rolling a single laminated sheet, the laminated structure causes heterogeneous deformation during working, and this heterogeneous laminated structure forms a factor deteriorating workability.

As a result of repeating study on the basis of this problem, it is preferable that the first and second laminated sheets are rolled in such a state that side end surfaces of both sides of the Nb-containing sheets and the X-containing sheets substantially align with each other.

Preferably in the aforementioned aspect, the first laminated sheet is rolled up from one end side to the other end side, one end side of the second laminated sheet is superposed and bonded to the other end side of the first laminated sheet in the course of rolling up the first laminated sheet, and the second laminated sheet is continuously rolled up from one end side to the other end side.

This is because rolling is simplified by starting to wind only one laminated sheet in the two laminated sheets around a core and superposing and winding one and the other laminated sheets with each other when the roll diameter relatively increases.

Preferably in the aforementioned aspect, end surfaces of the first Nb-containing sheet and the first X-containing sheet substantially align with each other at the other end of the first laminated sheet, and end surfaces of the second Nb-containing sheet and the second X-containing sheet substantially align with each other at one end of the second laminated sheet.

Thus, the Nb-containing sheets or the X-containing sheets are prevented from coming into contact with each other also on bonded portions of the first and second laminated sheets, and hence no deterioration of the superconducting characteristics such as reduction of the critical current value resulting from contact of the Nb-containing sheets or the X-containing sheets takes place.

Preferably in the aforementioned aspect, the second laminated sheet subsequently started to be rolled is rolled into the inner peripheral side of the first laminated sheet precedently started to be rolled.

Thus, the laminated sheet precedently started to be rolled fills the role of pressing the laminated sheet subsequently started to be rolled, and hence rolling is simplified.

The laminated sheets may be two, or the number of the sheets can be increased at need for increasing the number of layers.

Preferably in the aforementioned aspect, the first laminated sheet has a single-layer structure of either one of the first Nb-containing sheet and the first X-containing sheet at least at one end. The second laminated sheet has a single-layer structure of either one of the first Nb-containing sheet and the first X-containing sheet at least at one end. The first and second laminated sheets are so rolled up that portions of the first and second Nb-containing sheets forming the single-layer structures are in contact with each other.

The portions forming the single-layer structures are thus in contact with each other, so that the first and second laminated sheets can be more strongly connected.

Preferably in the aforementioned aspect, end surfaces of the Nb-containing sheet and the X-containing sheet substantially align with each other at the other end of the other laminated sheet having the other end located at the inner peripheral side beyond the other end of one laminated sheet in the first and second laminated sheets.

Thus, the Nb-containing sheets or the X-containing sheets are prevented from coming into contact with each other also on the connected portions of the first and second laminated sheets, and hence no deterioration of the superconducting characteristics such as reduction of the critical current value resulting from contact of the Nb-containing sheets or the X-containing sheets takes place.

Preferably in the aforementioned aspect, the first and second laminated sheets are wound around a core, the first laminated sheet has a singe-layer structure of the first Nb-containing sheet at one end, and a laminated portion of the single-layer structure of the first laminated sheet is employed as a mutual diffusion barrier layer for the core and the first X-containing sheet.

Thus, mutual diffusion of the core and the first X-containing sheet can be prevented.

Preferably in the aforementioned aspect, the first and second laminated sheets are wound around a core, a single-layer structure of the first laminated sheet consists of the first Nb-containing sheet, and a single-layer structure of the second laminated sheet consists of the second Nb-containing sheet. Laminated portions of the single-layer structures of the first and second laminated sheets are employed as mutual diffusion barrier layers for the core and the first and second X-containing sheets.

Thus, mutual diffusion of the core and the first and second X-containing sheets can be prevented. Further, the respective Nb-containing sheets of the first and second laminated sheets are in contact with each other, whereby the first and second laminated sheets can be more strongly connected.

Preferably in the aforementioned aspect, at least either one of the first and second laminated sheets rolled up from one end side to the other end side has a single-layer structure of the Nb-containing sheet at the other end. Only the single-layer structure of the Nb-containing sheet is rolled up on the outermost peripheral region where the first and second laminated sheets are rolled up.

Thus, mutual diffusion of a base material and the first and second Nb-containing sheets can be prevented.

Preferably in the aforementioned aspect, the atom X is at least either one of Al and Sn.

Preferably in the aforementioned aspect, a single-layer sheet consisting of a single layer of an Nb-containing sheet is rolled up from one end side to the other end side. One end of the first laminated sheet is butted against the other end of the rolled-up single-layer sheet, and the first laminated sheet is rolled up on the outer periphery of the single-layer sheet.

Preferably in the aforementioned aspect, one end of a single-layer sheet consisting of a single layer of an Nb-containing sheet is butted against an end portion of either one of the first and second laminated sheets located at the outermost periphery or held between the Nb-containing sheet and the X-containing sheet at the end portion of either one of the first and second laminated sheets located at the outermost periphery, and the single-layer sheet is further rolled up on the outer periphery where the first and second laminated sheets are rolled up. Thus, each of mutual diffusion of the core and the first and second X-containing sheets or mutual diffusion of the base material and the first and second Nb-containing sheets can be prevented.

A method of manufacturing a wire for a compound superconducting wire according to another aspect of the present invention is a method of superposing and rolling up an Nb-containing sheet consisting of pure Nb or an alloy containing Nb and an X-containing sheet consisting of a metallic atom X reacting with Nb and forming a compound exhibiting superconductivity or an alloy containing X, and comprises the following steps:

First, a first laminated sheet obtained by superposing a first Nb-containing sheet and a first X-containing sheet and a second laminated sheet obtained by superposing a second Nb-containing sheet and a second X-containing sheet are prepared. The first laminated sheet is rolled up from one end side to the other end side, one end of the second laminated sheet is connected to the other end side of the first laminated sheet in the course of rolling up the first laminated sheet, and the second laminated sheet is continuously rolled up from one end side to the other end side.

Also in the method according to this aspect, at least two laminated sheets are employed similarly to the method according to the aforementioned aspect, whereby a sufficient number of layers can be ensured even if employing short sides of the sheets decided by a reduction roll width for a laminate direction for a roll laminate.

Thus, it is possible to employ long sides in a roll direction for the length direction of the roll laminate, and elongation of the roll laminate can be readily attained without increasing the size of rolling equipment.

The length of a non-defective portion increases with respect to the length of a loss portion, whereby such a yield that non-defective products are obtained from supplied materials is improved as a result. Further, the number of roll laminates necessary for obtaining a prescribed final product reduces due to elongation of the roll laminate, and preparation of the roll laminate as well as preparation efficiency for a single-filamentary segment subsequent thereto are also improved.

In addition, the method includes no step of welding or the like for changing materials for a crystal structure or the like on the connected portions, and hence there is no problem of deterioration of workability either. While the Nb-containing sheets and the X-containing sheets are cut in the laminate direction on the connected portions and terminals of the sheets are included over the total length direction of the roll laminate, no influence on the workability by this is recognized and it has been confirmed that there is no problem in practice.

Connection may be performed on one portion, while it is also possible to increase the number of connection times at need for increasing the number of layers.

A wire for a compound superconducting wire manufactured by the methods of the aforementioned two aspects comprises first and second laminated sheets. The first laminated sheet is obtained by superposing a first Nb-containing sheet consisting of pure Nb or an alloy containing Nb and a first X-containing sheet consisting of a metallic atom X reacting with Nb and forming a compound exhibiting superconductivity or an alloy containing X. The second laminated sheet is obtained by superposing a second Nb-containing sheet consisting of pure Nb or an alloy containing Nb and a second X-containing sheet consisting of a metallic atom X reacting with Nb and forming a compound exhibiting superconductivity or an alloy containing X. The first and second laminated sheets are superposed and rolled up with each other so that the Nb-containing sheets and the X-containing sheets are alternately arranged.

Thus, a sufficient number of layers can be ensured by superposing and winding the first and second laminated sheets with each other, while there is no problem of deterioration of superconducting characteristics such as reduction of the critical current value observed when the Nb-containing sheets or the X-containing sheets are in contact with each other.

Preferably in the aforementioned aspect, the first and second laminated sheets are rolled up from one end side to the other end side, one end side of the first X-containing sheet and the other end side are located at the inner peripheral side and at the outer peripheral side, one end side of the second X-containing sheet is located at the outer periphery beyond one end of the first X-containing sheet and located at the inner peripheral side beyond the other end of the first X-containing sheet, and the other end of the second X-containing sheet is located at the outer peripheral side beyond the other end of the first X-containing sheet.

Preferably in the aforementioned aspect, the first and second laminated sheets are wound around a core, the first laminated sheet has a portion of a single-layer structure of the first Nb-containing sheet at one end, the second laminated sheet has a portion of a single-layer structure of the second Nb-containing sheet at one end side, and the portions of the single-layer structures of the first and second Nb-containing sheets are stacked between portions of the first and second X-containing sheets arranged at the innermost periphery and the core.

### Brief Description of the Drawings

Fig. 1 is a diagram for illustrating a first step of a method of manufacturing an Nb₃Al superconducting multi-filamentary wire in a first embodiment of the present invention.
Fig. 2 is a diagram for illustrating a second step of the method of manufacturing an Nb₃Al superconducting multi-filamentary wire in the first embodiment of the present invention.
Fig. 3 is a diagram for illustrating a third step of the method of manufacturing an Nb₃Al superconducting multi-filamentary wire in the first embodiment of the present invention.
Fig. 4 is a diagram for illustrating a fourth step of the method of manufacturing an Nb₃Al superconducting multi-filamentary wire in the first embodiment of the present invention.
Fig. 5 is a diagram for illustrating a fifth step of the method of manufacturing an Nb₃Al superconducting multi-filamentary wire in the first embodiment of the present invention.
Fig. 6 is a diagram for illustrating a sixth step of the method of manufacturing an Nb₃Al superconducting multi-filamentary wire in the first embodiment of the present invention.
Fig. 7 is a diagram for illustrating a seventh step of the method of manufacturing an Nb₃Al superconducting multi-filamentary wire in the first embodiment of the present invention.
Fig. 8 is a diagram showing the structure of the wire in Fig. 7 in an enlarged manner.
Fig. 9 is a diagram for illustrating a first step of a method of manufacturing an Nb₃Al superconducting multi-filamentary wire in a second embodiment of the present invention.
Fig. 10 is a diagram for illustrating a second step of the method of manufacturing an Nb₃Al superconducting multi-filamentary wire in the second embodiment of the present invention.
Fig. 11 is a diagram for illustrating a third step of the method of manufacturing an Nb₃Al superconducting multi-filamentary wire in the second embodiment of the present invention.
Fig. 12 is a diagram showing a wire portion of the Nb₃Al superconducting multi-filamentary wire in the second embodiment of the present invention in an enlarged manner.
Fig. 13 is a step diagram schematically showing a conventional method of manufacturing an Nb₃Al superconducting multi-filamentary wire according to a jelly roll method.
Fig. 14 is a diagram showing such a state that a sheet is rolled.

### Best Modes for Carrying Out the Invention

Embodiments of the present invention are now described with reference to the drawings.

### First Embodiment

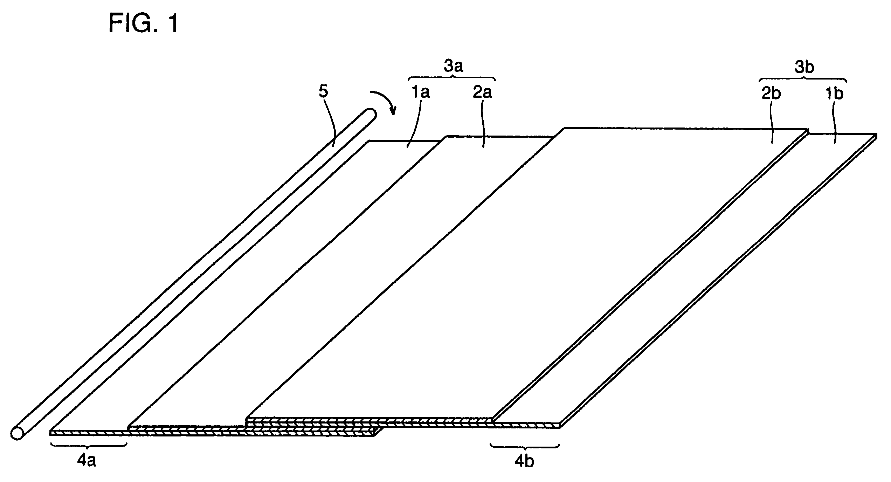

Fig. 1 to Fig. 7 are diagrams illustrating a method of manufacturing an Nb₃Al superconducting multi-filamentary wire according to a first embodiment of the present invention in step order.

Referring to Fig. 1, Nb-containing sheets 1a and 1b are first prepared by dissolution and rolling, and heat treatment, the so-called annealing, is performed on these Nb-containing sheets 1a and 1b. Al-containing sheets 2a and 2b each consisting of Al foil are superposed on the surfaces of these heat-treated Nb-containing sheets 1a and 1b. At this time, single end portions of the Nb-containing sheets 1a and 1b are not covered with the Al-containing sheets 2a and 2b. Thus, a laminated sheet 3a consisting of the Nb-containing sheet 1a and the Al-containing sheet 2a and a laminated sheet 3b consisting of the Nb-containing sheet 1b and the Al-containing sheet 2b are formed. Portions 4a and 4b where Nb is exposed in the laminated sheets 3a and 3b are portions which can serve as diffusion barrier layers.

These laminated sheets 3a and 3b are successively wound around a copper bar 5. At this time, the laminated sheet 3a is wound from the exposed portion 4a of the Nb-containing sheet 1a. The laminated sheet 3b is wound from a side where the Nb-containing sheet 1b is not exposed toward an exposed side. At this time, the first and second laminated sheets 3a and 3b are so wound that the Nb-containing sheets and the Al-containing sheets are alternately arranged.

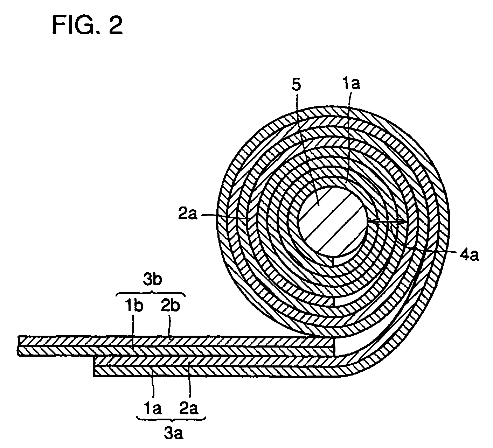

Referring to Fig. 2, the two laminated sheets 3a and 3b are bonded to each other in the course of winding around the copper bar 5. The method for this bonding is carried out by rolling the laminated sheet 3b in between the already wound outer peripheral surface of the laminated sheet 3a and the inner peripheral surface of the portion to be then wound, for example. The laminated sheet 3b is continuously wound from this bonded portion.

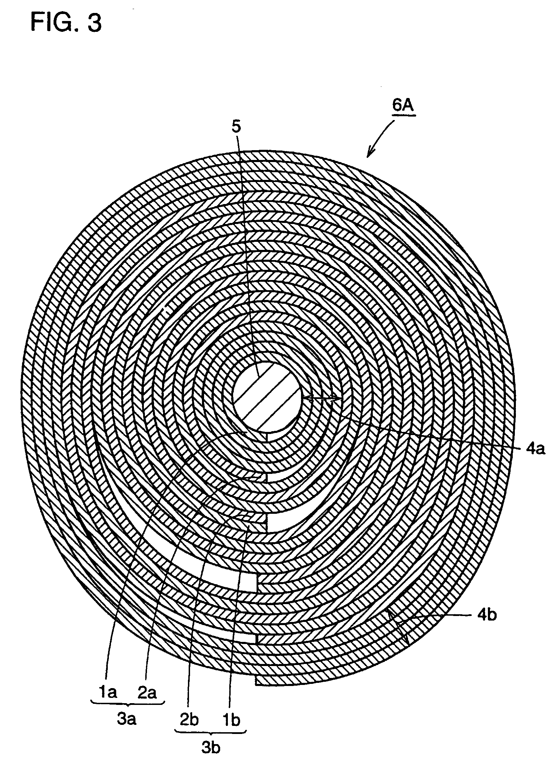

Referring to Fig. 3, a roll laminate 6A is thus formed. The innermost peripheral region coming into contact with the copper bar 5 in this roll laminate 6A is a laminate region 4a of only the Nb-containing sheet 1a. This laminate region 4a serves as a barrier layer for mutual diffusion of the copper bar 5 and the Al-containing sheets 2a and 2b. A laminate region 4b of only the Nb-containing sheet 1b is formed on the outermost peripheral region of the roll laminate 6A. This laminate region 4b selves as a barrier layer for mutual diffusion of the Al-containing sheets 2a and 2b and a base material.

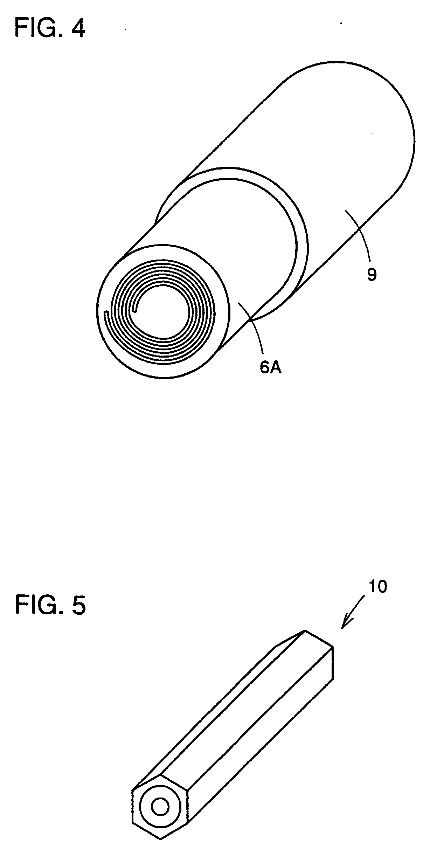

Referring to Fig. 4, this roll laminate 6A is inserted in a copper pipe 9, and thereafter subjected to wire drawing.

Referring to Fig. 5, a hexagonal segment 10 having a hexagonal section is thus prepared.

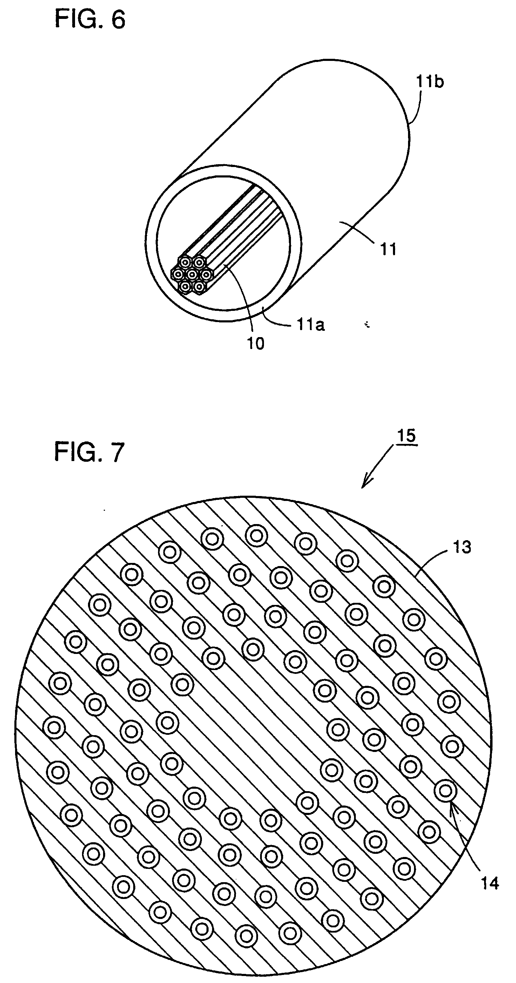

Referring to Fig. 6, a plurality of such hexagonal segments 10 are charged into a copper pipe 11 in a bundle. Both ends 11a and 11b of the copper pipe 11 are dosed with lids (not shown) of copper and sealed by electron beam welding, so that a billet (not shown) is prepared. Then, extrusion and wire drawing are repeated on this billet, so that a multi-filamentary wire 15 shown in Fig. 7 is formed.

The multi-filamentary wire 15 is formed by embedding a number of wires 14 made of Nb, Al and Cu in a base material 13 consisting of Cu, for example.

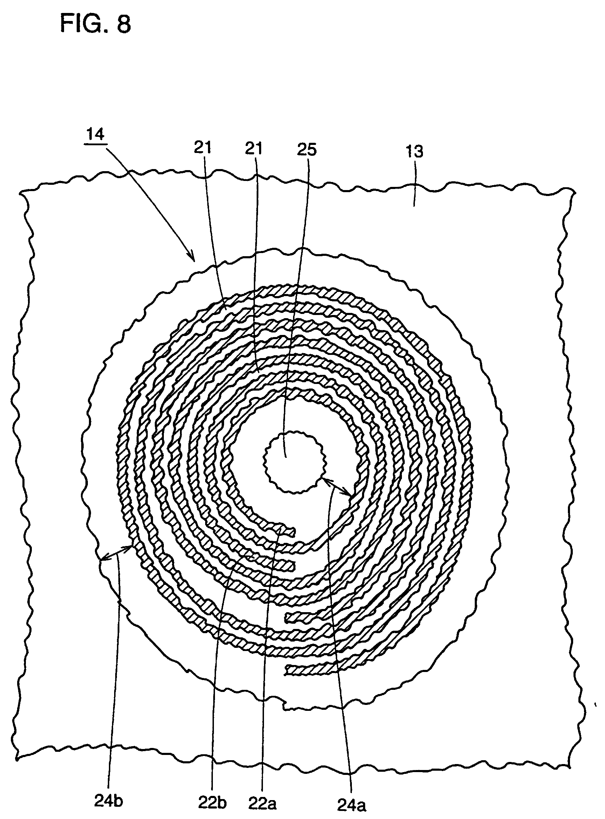

Fig. 8 is a diagram showing the structure of each wire 14 in the multi-filamentary wire 15 of Fig. 7 in an enlarged manner. Referring to Fig. 8, a copper matrix 25 is formed on the central portion, and a diffusion barrier layer 24a containing Nb is formed to enclose the same. On the outer periphery of this diffusion barrier layer 24a, Al-containing layers 22a and 22b are formed at a space to be spiral. An Nb-containing layer 21 is formed in the clearance between the spiral Al-containing layers 22a and 22b. A diffusion barrier layer 24b containing Nb is formed on the outermost periphery thereof.

### Second Embodiment

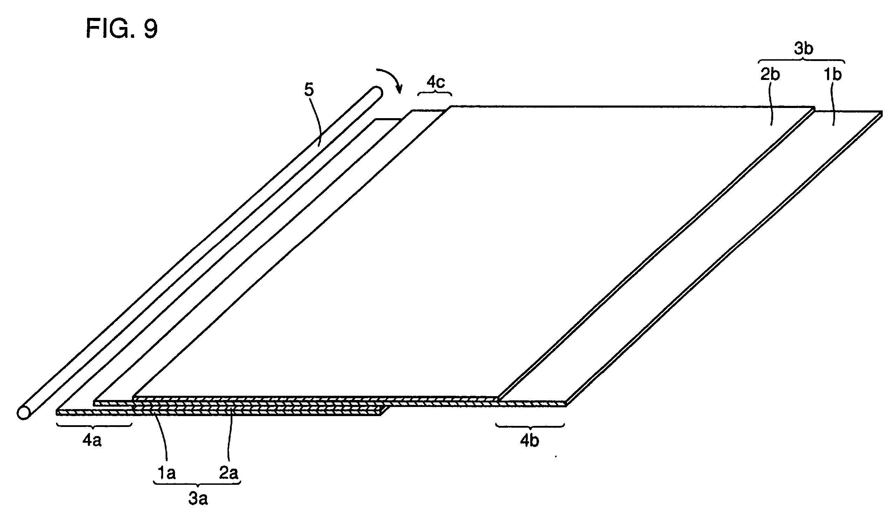

Fig. 9 to Fig. 11 are diagrams illustrating a method of manufacturing an Nb₃Al superconducting multi-filamentary wire according to a second embodiment of the present invention in step order.

Referring to Fig. 9, a laminated sheet 3a in which an Nb-containing sheet 1a and an Al-containing sheet 2a are superposed with each other and a laminated sheet 3b in which an Nb-containing sheet 1b and an Al-containing sheet 2b are superposed with each other are wound around a copper bar 5 also in this embodiment, similarly to the first embodiment. However, the state of superposition of the Nb-containing sheet 1b and the Al-containing sheet 2b in the laminated sheet 3b and the state of superposition of the laminated sheets 3a and 3b are different from the first embodiment.

In this embodiment, single-layer regions 4b and 4c of the Nb-containing sheet on which the Al-containing sheet 2b is not superposed are present on both end portions of the laminated sheet 3b.

The laminated sheets 3a and 3b are so superposed with each other that an Nb single-layer region 4a and the Nb single-layer region 4c overlap in contact with each other when wound around the copper bar 5.

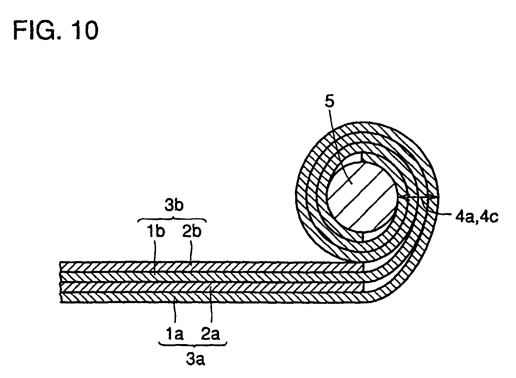

Referring to Fig. 10, the laminated sheets 3a and 3b are wound around the copper bar 5 in this superposition state.

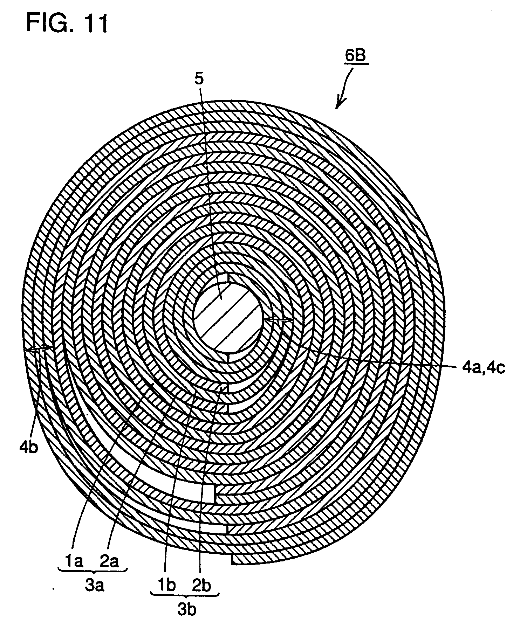

Referring to Fig. 11, a roll laminate 6B is thus formed. In this roll laminate 6B, regions 4a and 4b where only the Nb-containing sheets 1a and 1b are stacked in contact with each other are formed on the innermost peripheral region coming into contact with the copper bar 5. Further, a laminate region 4b of only the Nb-containing sheet 1b is formed on the outermost peripheral region of the roll laminate 6B.

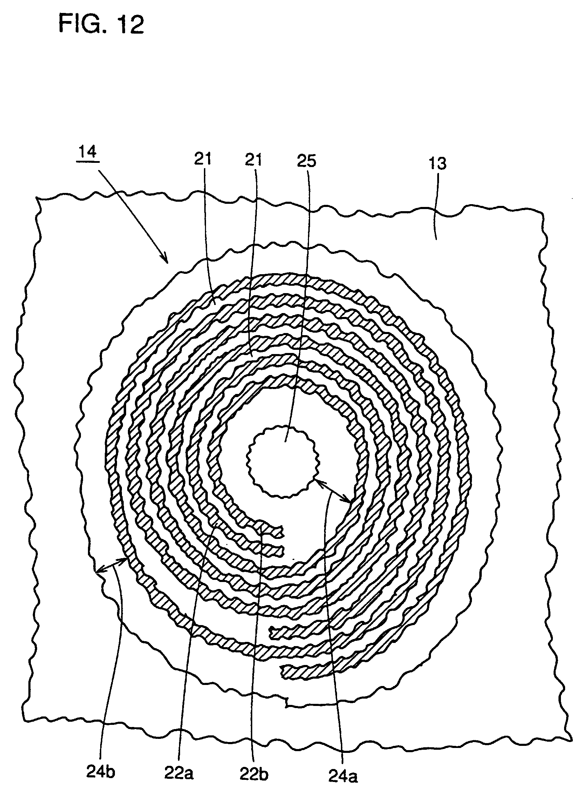

Thereafter a multi-filamentary wire 15 shown in Fig. 7 is formed through steps similar to those of the first embodiment shown in Fig. 4 to Fig. 6. A wire 14 in a Cu member 13 has a structure shown in Fig. 12 in this multi-filamentary wire 15.

Referring to Fig. 12, it is most to be noted here that a mutual diffusion barrier layer 24a is formed on the innermost periphery coming into contact with a Cu matrix 25, and this diffusion barrier layer 24a is formed by the two Nb-containing sheets 1a and 1b.

For the convenience of illustration, the same numerals are assigned to components identical to those in the first embodiment 1, and description thereof is not repeated.

In the first and second embodiments, it is preferable that end surfaces of roll end sides of the Nb-containing sheet 1a and the Al-containing sheet 2a substantially align with each other. Further, it is preferable that end surfaces of roll start sides of the Nb-containing sheet 1b and the Al-containing sheet 2b also substantially align with each other in the first embodiment.

The Al-containing sheet 2b may simply consist of a material having a metallic atom X reacting with Nb and forming a compound exhibiting superconductivity or an alloy containing X, and more specifically, Sn is available in place of Al.

While description has been made on such examples that the single-layer portions of the Nb-containing sheets of the laminated sheets 3a and 3b are provided on the innermost peripheral region or the outermost peripheral region in relation to the aforementioned embodiments, a single layer of an Nb-containing sheet independent of the laminated sheets 3a and 3b may be further wound on the innermost peripheral region or the outermost peripheral region and to serve as a mutual diffusion layer.

Examples of the present invention are now described.

### First Example

### 〈Inventive Example〉

Nb sheets 1a and 1b of 250 mm by 1000 mm (rolling direction) and Al sheets 2a and 2b of 200 to 250 mm by 1000 mm (rolling direction) were employed, the rolling direction (direction of arrow B in Fig. 14) of each sheet was arranged along the axial direction of a copper bar 5 and two laminated sheets 3a and 3b were added for preparing a roll laminate 6A having a length L (Fig. 13) of 1000 mm such as that shown in Fig. 3. This roll laminate 6A was inserted into a copper pipe 9 as shown in Fig. 4, and wire drawing was performed for preparing a single-filamentary wire. The single-filamentary wire was cut into a length of 120 mm excluding defective portions on both ends, and 228 ones were further inserted into a copper pipe 11 in a bundle as shown in Fig. 6, and extrusion and wire drawing were performed for preparing a multi-filamentary wire 15 of 0.8 mm such as that shown in Fig. 7.

### 〈Comparative Example〉

An Nb sheet of 250 mm by 1000 mm (rolling direction) and an Al sheet of 200 to 250 mm by 1000 mm (rolling direction) were employed similarly to inventive Example and only a single laminated sheet was wound around a core while arranging a rolling direction (direction of arrow B in Fig. 14) in a laminate direction (direction of arrow A in Fig. 13) without performing addition. A roll laminate having a length of 250 mm was thus prepared. Thereafter a multi-filamentary wire of 0.8 mm was prepared by the same method as the inventive Example.

### 〈Results〉

Table 1 shows results obtained by investigating laminate yields, numbers of disconnection times, critical current densities and the like as to the aforementioned multi-filamentary wires of inventive Example and comparative example.

**Table 1**

| | Length of Laminate | Yield of Laminate | Number of Laminates Necessary for Multi-Filamentary Wire of 100 kg | Number of Disconnection Times | Critical Current Density (12 T) |
|---|---|---|---|---|---|
| Comparative Example | 250 mm | 75% | 220 | 0 | 710A/mm² |
| Inventive Example | 1000 mm | 94% | 44 | 0 | 715A/mm² |

The ratio (laminate yield) of a non-defective portion of the roll laminate according to inventive Example was improved by about 20 % as compared with comparative example. The number of roll laminates necessary for preparing a multi-filamentary wire of 100 kg obtained by taking this yield into consideration is reduced to 1/5. As obvious from this, the preparation efficiency for a single-filamentary segment is also remarkably improved.

Further, it was possible to work the wires of inventive Example and comparative example into 0.8 mm with no occurrence of disconnection similarly to comparative example, and the critical current densities in a magnetic field of 12 T at the liquid helium temperature were also substantially identical. Thus, it has been confirmed that workability and superconducting characteristics of the wire do not deteriorate even if employing the roll laminate prepared by the method of the present invention.

### Second Example

### 〈Inventive Example〉

Nb sheets of 250 mm by 1000 mm (rolling direction) and Al sheets of 200 to 250 mm by 1000 mm (rolling direction) were employed, and each sheet was wound around a copper bar 5 while arranging the rolling direction (direction of arrow B in Fig. 14) in the axial direction of the copper bar 5 in accordance with the method described with reference to Fig. 9. At this time, a laminated sheet 3a was first wound around the copper bar 5 to have two turns, and thereafter a laminated sheet 3b was inserted into the inner peripheral side of the laminated sheet 3a so that an Nb single-layer region 4a of the laminated sheet 3a and an Nb single-layer region 4c of the laminated sheet 3b were in contact with each other, for winding the laminated sheets 3a and 3b together. Thus, a roll laminate 6B having a length L of 1000 mm was prepared. This roll laminate 6B was inserted into a copper pipe 9 as shown in Fig. 4, and wire drawing was performed for preparing a single-filamentary wire. The single-filamentary wire was cut into a length of 120 mm exduding defective portions on both ends, and 228 ones were further inserted into a copper pipe 11 in a bundle as shown in Fig. 6 for performing extrusion and wire drawing, thereby preparing a multi-filamentary wire 15 of 0.8 mm such as that shown in Fig. 7.

### 〈Comparative Example〉

An Nb sheet of 250 mm by 1000 mm (rolling direction) and an Al sheet of 200 to 250 mm by 1000 mm (rolling direction) were employed similarly to inventive Example, and only a single laminated sheet was wound while arranging the rolling direction (direction of arrow B in Fig. 14) in a laminate direction (direction of arrow A in Fig. 13) without performing addition. A roll laminate having a length of 250 mm was thus prepared. Thereafter a multi-filamentary wire of 0.8 mm was prepared by the same method as the aforementioned inventive Example.

### 〈Results〉

Table 2 shows results obtained by investigating laminate yields, numbers of disconnection times, critical current densities and the like as to the aforementioned multi-filamentary wires of inventive Example and comparative example.

**Table 2**

| | Length of Laminate | Yield of Laminate | Number of Laminates Necessary for Multi-Filamentary Wire of 100 kg | Number of Disconnection Times | Critical Current Density (12 T) |
|---|---|---|---|---|---|
| Comparative Example | 250 mm | 75% | 220 | 0 | 710A/mm² |
| Inventive Example | 1000 mm | 94% | 44 | 0 | 705A/mm² |

The ratio (laminate yield) of a non-defective portion of the roll laminate according to inventive Example was improved by about 20 % as compared with comparative example. The number of roll laminates necessary for preparing a multi-filamentary wire of 100 kg obtained by taking this yield into consideration is reduced to 1/5. As obvious from this, the preparation efficiency for a single-filamentary segment is also remarkably improved.

Further, it was possible to work the wires of inventive Example and comparative example into 0.8 mm with no occurrence of disconnection similarly to comparative example, and the critical current densities in a magnetic field of 12 T at the liquid helium temperature were also substantially identical. Thus, it has been confined that workability and superconducting characteristics of the wire do not deteriorate even if employing the roll laminate prepared by the method of the present invention.

According to the inventive method of manufacturing a wire for a compound superconducting wire, as hereinabove described, at least two laminated sheets are employed and hence a sufficient number of layers can be ensured even if employing short sides of the sheet decided by a reduction roll width for the laminate direction of the roll laminate. Thus, it is possible to employ longer sides in the rolling direction for the length direction of the roll laminate, and elongation of the roll laminate can be readily attained without increasing the size of rolling equipment.

While the roll laminate is worked into a single-filamentary wire by extrusion or wire drawing, it is unavoidable that a terminal portion of a constant length decided by working equipment sustains a loss. However, the length of a non-defective portion increases with respect to the length of the loss portion due to elongation of the roll laminate, and such a yield that non-defective products are obtained from supplied materials is improved as a result.

Further, the number of roll laminates necessary for obtaining a prescribed final product reduces due to elongation of the roll laminate, and preparation of the roll laminate as well as the preparation efficiency for the single-filamentary segment subsequent thereto are also improved.

Embodiments and Examples disclosed this time must be regarded as illustrative and not restrictive in all points. The scope of the present invention is shown not by the above description but by the scope of claim for patent, and it is intended that all modifications within the meaning and the range equivalent to the scope of claim for patent are included.

### Industrial Availability

The present invention is advantageously applicable to a wire for a compound superconducting wire used for a superconducting magnet which can be employed for nuclear fusion, superconducting energy storage, a particle accelerator or other use and a method of manufacturing the same.

## Claims

1. A method of manufacturing a wire for a compound superconducting wire formed by superposing and rolling up an Nb-containing sheet consisting of pure Nb or an alloy containing Nb and an X-containing sheet consisting of a metallic atom X reacting with said Nb and forming a compound exhibiting superconductivity or an alloy containing X with each other, characterized in:
preparing a first laminated sheet obtained by superposing a first Nb-containing sheet and a first X-containing sheet and a second laminated sheet obtained by superposing a second Nb-containing sheet and a second X-containing sheet; and
superposing and rolling up said first and second laminated sheets so that said Nb-containing sheets and said X-containing sheets alternately overlap with each other.

2. The method of manufacturing a wire for a compound superconducting wire in accordance with claim 1, wherein said first laminated sheet is rolled up from one end side to the other end side,
one end side of said second laminated sheet is superposed and bonded to said other end side of said first laminated sheet in the course of rolling up said first laminated sheet, and
said second laminated sheet is continuously rolled up from said one end side to the other end side.

3. The method of manufacturing a wire for a compound superconducting wire in accordance with claim 2, wherein end surfaces of said first Nb-containing sheet and said first X-containing sheet substantially align with each other at said other end of said first laminated sheet, and
end surfaces of said second Nb-containing sheet and said second X-containing sheet substantially align with each other at said one end of said second laminated sheet.

4. The method of manufacturing a wire for a compound superconducting wire in accordance with claim 1, wherein said first laminated sheet has a single-layer structure of either one of said first Nb-containing sheet and said first X-containing sheet at least at one end,
said second laminated sheet has a single-layer structure of either one of said second Nb-containing sheet and the second X-containing sheet at least at one end, and
said first and second laminated sheets are rolled up from said one end side to the other end side so that portions of said first and second laminated sheets forming said single-layer structures are in contact with each other.

5. The method of manufacturing a wire for a compound superconducting wire in accordance with claim 4, wherein end surfaces of said Nb-containing sheet and said X-containing sheet substantially align with each other at said other end of the other said laminated sheet having the other end located at the inner peripheral side beyond the other end of said laminated sheet being one of said first and second laminated sheets.

6. The method of manufacturing a wire for a compound superconducting wire in accordance with claim 1, rolling an end portion of said second laminated sheet subsequently started to be rolled into the inner peripheral side of said first laminated sheet precedently started to be rolled.

7. The method of manufacturing a wire for a compound superconducting wire in accordance with claim 2, wherein said first and second laminated sheets are wound around a core, and
said first laminated sheet has a single-layer structure of said first Nb-containing sheet at said one end, and a laminated portion of said single-layer structure of said first laminated sheet is employed as a mutual diffusion barrier layer for said core and said first X-containing sheet.

8. The method of manufacturing a wire for a compound superconducting wire in accordance with claim 4, wherein said first and second laminated sheets are wound around a core,
said single-layer structure of said first laminated sheet consists of said first Nb-containing sheet, said single-layer stricture of said second laminated sheet consists of said second Nb-containing sheet, and
laminated portions of said single-layer structures of said first and second laminated sheets are employed as mutual diffusion barrier layers for said core and said first and second X-containing sheets.

9. The method of manufacturing a wire for a compound superconducting wire in accordance with claim 1, wherein at least either one of said first and second laminated sheets rolled up from one end side to the other end side has a single-layer structure of said Nb-containing sheet at said other end, and
only said single-layer stricture of said Nb-containing sheet is rolled up on the outermost peripheral region where said first and second laminated sheets are rolled up.

10. The method of manufacturing a wire for a compound superconducting wire in accordance with claim 1, wherein said metallic atom X includes at least either one of Al and Sn.

11. The method of manufacturing a wire for a compound superconducting wire in accordance with claim 2, rolling up a single-layer sheet consisting of a single layer of an Nb-containing sheet from one end side to the other end side, butting one end of said first laminated sheet against the other end of rolled-up said single-layer sheet and rolling up said first laminated sheet on the outer periphery of said single-layer sheet.

12. The method of manufacturing a wire for a compound superconducting wire in accordance with claim 1, butting one end of a single-layer sheet consisting of a single layer of an Nb-containing sheet against an end portion of either one of said first and second laminated sheets located at the outermost periphery or holding said one end between said Nb-containing sheet and said X-containing sheet at the end portion of either one of said first and second laminated sheets located at the outermost periphery and further rolling up said single-layer sheet on the outer periphery where said first and second laminated sheets are rolled up.

13. A method of manufacturing a wire for a compound superconducting wire formed by superposing and rolling up an Nb-containing sheet consisting of pure Nb or an alloy containing Nb and an X-containing sheet consisting of a metallic atom X reacting with said Nb and forming a compound exhibiting superconductivity or an alloy containing X with each other, characterized in:
preparing a first laminated sheet obtained by superposing a first Nb-containing sheet and a first X-containing sheet and a second laminated sheet obtained by superposing a second Nb-containing sheet and a second X-containing sheet;
rolling up said first laminated sheet from one end side to the other end side and connecting one end side of said second laminated sheet to said other end side of said first laminated sheet in the course of rolling up said first laminated sheet; and
continuously rolling up said second laminated sheet from said one end side to the other end side.

14. A wire for a compound superconducting wire comprising:
a first laminated sheet obtained by superposing a first Nb-containing sheet consisting of pure Nb or an alloy containing Nb and a first X-containing sheet consisting of a metallic atom X reacting with said Nb and forming a compound exhibiting superconductivity or an alloy containing X; and
a second laminated sheet obtained by superposing a second Nb-containing sheet consisting of pure Nb or an alloy containing Nb and a second X-containing sheet containing a metallic atom X reacting with said Nb and forming a compound exhibiting superconductivity or an alloy containing X, wherein
said first and second laminated sheets are superposed and rolled up with each other so that said Nb-containing sheets and said X-containing sheets are alternately arranged.

15. The wire for a compound superconducting wire in accordance with claim 14, wherein said first and second laminated sheets are rolled up from one end side to the other end side, said one end side of said first X-containing sheet and said other end side are located at the inner peripheral side and at the outer peripheral side respectively, one end side of said second X-containing sheet is located at the outer periphery beyond said one end of said first X-containing sheet and located at the inner peripheral side beyond said other end of said first X-containing sheet, and the other end of said second X-containing sheet is located at the outer peripheral side beyond said other end of said first X-containing sheet.

16. The wire for a compound superconducting wire in accordance with claim 12, wherein said first and second laminated sheets are wound around a core,
said first laminated sheet has a portion of a single-layer structure of said first Nb-containing sheet at one end,
said second laminated sheet has a portion of a single-layer structure of said second Nb-containing sheet at one end, and
a portion where the single-layer structures of said first and second Nb-containing sheets is held between portions of said first and second X-containing sheets arranged at the innermost periphery and said core.
